# EUROPEAN PATENT SPECIFICATION

(11) **EP 2 343 173 B1**
(45) Date of publication and mention of the grant of the patent: **05.07.2017**
(21) Application number: 11150198.7
(22) Date of filing: 05.01.2011
(51) Int. Cl.: B28D 1/22, B28D 5/00, H01L 31/18, H01L 31/20, H01L 31/046, H01L 21/67

(54) **Groove machining tool for use with a thin-film solar cell**
Rillenbearbeitungswerkzeug zur Verwendung mit einer Dünnschicht-Solarzelle
Machine pour usiner une rainure pour une utilisation avec une cellule solaire à couche mince

(30) Priority: 08.01.2010 JP 2010002497; 03.12.2010 JP 2010270200
(43) Date of publication of application: 13.07.2011
(73) Proprietor: Mitsuboshi Diamond Industrial Co., Ltd., Suita-city, Osaka 564-0044 (JP)
(72) Inventor: Akai, Toshio, Suita City Osaka 564-0044 (JP); Okamoto, Keitaro, Suita City Osaka 564-0044 (JP); Soyama, Masanobu, Suita City Osaka 564-0044 (JP)
(74) Representative: TBK

(56) References cited:
- WO-A1-2010/098306
- JP-A- 2000 315 809

## Description

### BACKGROUND OF THE INVENTION

### 1. Field of the Invention

The present invention relates to a groove machining tool, and particularly to a groove machining tool that is supported in a holder and is caused to move together with the holder in relative fashion along a scheduled scribe line over an integrated thin-film solar cell substrate to form a groove.

### 2. Description of the Related Art

When manufacturing integrated thin-film solar cells, a stripe-shaped groove is formed for purposes of insulation by scribing and removing a thin film formed on the substrate. As a tool for forming a groove, a tool such as the one described in Patent Document 1 has been used. The tool described in Patent Document 1 has a blade tip shaped as a needle or a flat chisel. By causing this tool to move in the direction of the formation of the groove, a stripe-shaped groove is formed.

In the tool described in Patent Document 1, the detachment of the area around the film end adjacent to the scribe line becomes large when the blade tip becomes round due to friction and the machining quality of the groove decreases.

To that end, a tool such as the one described in Patent Document 2 and the manufacturing method thereof have been provided. According to the manufacturing method of Patent Document 2, a groove-forming tool and a peeling tool are used to form a stripe-shaped groove in a thin film.

The groove forming tool has two protrusions shaped as triangular pyramids at both ends of the width of the tool, the width being orthogonal to the direction of movement of the tool during machining. A circular, vertically depressed indentation is formed between these two protrusions. Further, the peeling tool has a flat blade tip of approximately the same width as the groove.

When forming a groove, first, the groove forming tool is made to move in the direction of groove formation, thereby forming two stripe-shaped grooves in places corresponding to two ends of the width of the groove. Thereafter, the peeling tool is made to move in the direction of groove formation in the same manner, and the thin film remaining between the two stripe-shaped grooves is peeled off.

Japanese Unexamined Utility Model Registration Application Publication No. 63-16439 (Patent Document 1) and Japanese Unexamined Patent Application Publication No. 2002-33498 (Patent Document 2) are examples of the related art. Further examples of the related art are JP2000315809 A and WO2010098306 A1, which both disclose a groove machining tool for thin-film solar cells comprising a tool body, a blade tip part including a blade, the blade being tilted backward from the direction of movement of the tool.

### SUMMARY

When a groove is machined using the groove forming tool described in Patent Document 2, peeling-off of the film at the edges of the groove is reduced, but it cannot be said that a groove machined with sufficient quality is obtainable. When peeling-off of the film during groove machining is not sufficiently reduced, a patterning line cannot be formed accurately, and the problem of reduction of power generation efficiency of the solar cell substrate arises.

According to the method described in Patent Document 2, first, two grooves are formed with the groove forming tool, and thereafter the remaining film is peeled off with the peeling tool. Two processes are therefore necessary in order to form a groove. Thus, machining time becomes longer. Also, two tools, the groove forming tool and the peeling tool, are necessary in order to form a groove.

An object of the present invention is to obtain a groove machining tool whereby peeling-off of the film at the edges of a groove when forming the groove is reduced, and whereby grooves can be machined by an easy process and with high quality.

The groove machining tool for use with a thin-film solar cell according to a first aspect of the present invention is a tool supported in a holder and caused to move together with the holder in relative fashion along a scheduled scribe line over an integrated thin-film solar cell substrate to form a groove. The groove machining tool includes a tool body, supported by the holder, and a blade tip part formed at the distal part of the tool body. The blade tip part has a blade extending along a direction intersecting a direction of movement of the tool at an end along the direction of movement of the tool; and wherein a portion of the blade extending from a first end to a second end and including at least part of the first end is tilted backward from the direction of movement of the tool in relation to a direction orthogonal to the direction of movement of the tool, as viewed from a bottom face of the blade tip part.

In this groove machining tool, the blade of the blade tip part is tilted backward from the direction of movement of the tool in relation to the direction of movement of the tool, as viewed from a bottom face. Therefore, when the groove machining tool is caused to move relative to a substrate and form a groove, an end of the groove is cut by the edge. For this reason, the end part of the groove is cut with a stronger sheering force, and peeling-off of film in portions other than the groove can be reduced. Furthermore, the blade is tilted from the first end to the second end, and the film removed from the end part of the groove is therefore smoothly expelled towards the center portion of the groove along the tilted face of the blade. For this reason, the worsening of cutting ability by the removed film is reduced, and a groove can be machined with stable, high quality. Additionally, it is not necessary to use two tools as was necessary in conventional methods.

The groove machining tool for use with a thin-film solar cell according to a second aspect of the present invention is the groove machining tool according to the first aspect, wherein a blade as viewed from a bottom face of the blade tip part is tilted at the same angle from the first end to the second end.

In this case, the thin film removed by the first edge of the blade can be smoothly expelled towards the second edge, and the machining quality of the groove is stabilized.

The groove machining tool for use with a thin-film solar cell according to a third aspect of the present invention is the groove machining tool according to the first aspect, wherein a blade of the blade tip part has a pair of edges formed at the first end and the second end, and an inwardly sunken flank part (concave) is formed between the pair of edges.

In this configuration, the center of the groove is removed by the flank part while both ends in the width direction of the groove are removed by the pair of edges. In this way, simply by causing the groove machining tool to move in the direction of groove formation, the both ends in the width direction of the groove, as well as the center of the groove, are scribed, and the groove can be made via a one-step process. Also, the flank part formed between the pair of edges is sunken inward, and the phenomenon of the entire blade tip becoming round can therefore be reduced even if the edges become worn down due to friction. For this reason, good machining quality can be maintained over a long period of time.

The groove machining tool for use with a thin-film solar cell according to a fourth aspect of the present invention is the groove machining tool according to the third aspect, wherein the surface including the pair of edges of the blade tip and the lower end border of the flank part is parallel with the surface of the thin-film when positioned for machining.

In this case, simply by causing the tool to move in one direction, both ends of the groove in the width direction of the groove can be cut with high machining quality, in the same way as the third aspect.

The groove machining tool for use with a thin-film solar cell according to a fifth aspect of the present invention is the groove machining tool according to the first aspect, wherein the blade tip part has a blade extending along a direction intersecting a direction of movement of the tool, at another end along the direction of movement of the tool; and wherein a portion of the blade extending from the first end to the second end and including at least part of the first end is tilted backward from the direction of movement of the tool in relation to a direction orthogonal to the direction of movement of the groove tool, as viewed from a bottom face of the blade tip part.

In this case, a blade is formed at the blade tip part of the tool at both ends along the direction of movement of the tool. Therefore, when the blade at one end along the direction of movement of the tool is worn down due to friction, the mounting direction of the tool can be changed, and the blade at the other end along the direction of movement of the tool can be used. Moreover, when the tilt of the blade of the blade tip part at one end along the direction of movement of the tool and the blade at the other end along the direction of movement of the tool are reversed, a groove of high machining quality can be formed during movement in both directions, one being the coming directional movement, and the other being the going directional movement.

The groove machining tool for use with a thin-film solar cell according to a sixth aspect of the present invention is the groove machining tool according to the fifth aspect, wherein the blade of the blade tip part at one end along the direction of movement of the tool, and the blade of the blade tip part at another end along the direction of movement of the tool are tilted in the same direction and at the same angle.

In this case, when the blade at one end along the direction of movement of the tool is worn down due to friction, the mounting direction of the tool can be changed, and the blade at the other end along the posterior end of the direction of movement of the tool can be used.

The groove machining tool for use with a thin-film solar cell according to a seventh aspect of the present invention is the groove machining tool according to the fifth aspect, wherein the blade of the blade tip part at one end along the direction of movement of the tool, and the blade of the blade tip part at another end along the direction of movement of the tool are tilted in opposite directions at the same angle.

In this case, when moving in both the coming and going directions, a groove of high machining quality can be formed.

The groove machining tool for use with a thin-film solar cell according to an eighth aspect of the present invention is the groove machining tool according to the first aspect, wherein the blade tip part extends for the same width along the entire width of the tool body and along the direction in which the grove is formed on the thin-film.

In this arrangement, the blade tip part extends with the same width along the direction of formation of the groove. For this reason, even if the blade tip is worn down due to friction, the same tool can continue to be used by simply forming a relief through repair machining.

The groove machining tool for use with a thin-film solar cell according to a ninth aspect of the present invention is the groove machining tool according to any one of the aspects among the first to eighth aspects, wherein the tool body is formed into a square shape.

According to the tool of this aspect, it is necessary to fix the position of the tool when machining a groove. In other words, if the tool were attached to the holder at a slant with respect to the direction the groove is to be formed, then the groove would not be scribed with the desired groove-width, or the quality of the cut at the groove end by the tool edge would be reduced.

As noted above, in order to prevent defects arising from deviations in the mounting angle of the tool, calibration of the mounting angle of the tool is necessary at times such as when replacing the tool. Conventionally, this calibration was carried out by mounting the tool and the holder in a separate tool angle calibration device, and the tool mounting angle was verified by microscope. This kind of calibration is extremely troublesome, and requires a great deal of time.

Therefore, according to the ninth aspect, the tool body is made to be square. In this case, by simply forming a square groove in the holder and fitting the tool body into this groove, the tool mounting angle can be controlled. For this reason, when mounting the groove machining tool into the holder, mounting with accurate positioning is possible by a simple operation.

In the present invention as described above, it is possible, in particular, to reduce thin peeling at the edge of a groove when the groove is formed during groove machining of a thin-film solar cell. Further, the film can be reliably removed using one tool, and a groove of a stable quality can always be formed.

### BRIEF DESCRIPTION OF THE DRAWINGS

FIG. 1 is an exterior perspective view of a scribe device wherein one embodiment of the present invention is used;
FIG. 2 is a front view of a holder assembly according to the first embodiment;
FIG. 3 is a side view of FIG. 2;
FIG. 4 is an exterior perspective view of a groove machining tool, an expanded view of one portion thereof, and a bottom view;
FIG. 5 is a diagram illustrating an example of a groove machining experiment;
FIG. 6 is a diagram illustrating and example of groove machining according to a modification of the first embodiment, which is not part of the present invention;
FIG. 7 is a bottom view of a groove machining tool of the second embodiment, which is not part of the present invention;
FIG. 8 is a bottom view of a groove machining tool of the third embodiment, which is not part of the present invention;
FIG. 9 is a front view of a reciprocating head into which is mounted a groove machining tool of the third embodiment, which is not part of the present invention; and
FIG. 10 is an exterior perspective view of a groove machining tool of the fourth embodiment, which is not part of the present invention, and an expanded view of one portion thereof.

### DESCRIPTION OF THE PREFERRED EMBODIMENTS

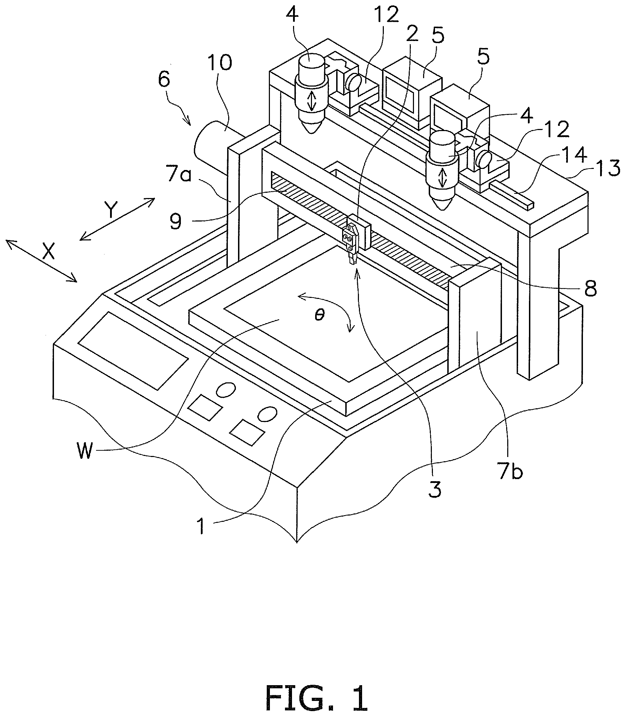

FIG. 1 shows an exterior perspective view of the outside of an integrated thin-film solar cell scribe device wherein an embodiment of the present invention is used.

### First embodiment

### Overall Configuration of the Scribe Device

This device includes a table 1, onto which a solar cell substrate W is placed, a scribe head 2, a holder assembly 3 installed onto the scribe head 2, and two cameras 4 and two monitors 5.

The table 1 can move in the horizontal plane, in a Y direction in FIG. 1. Also, the table 1 is freely rotatable within the horizontal plane.

The scribe head 2 can move in an X and the Y directions on top of the table 1 via a movement control mechanism 6. As illustrated in FIG. 1, the X direction is orthogonal to the Y direction in the horizontal plane. The movement control mechanism 6 includes one pair of support pillars 7a and 7b, a guide bar 8 crossing between the pair of support pillars 7a and 7b, and a motor 10 that moves a guide 9 formed on the guide bar 8. The scribe head 2 can move, as previously stated in the X direction along the guide 9. An air cylinder (not shown) is disposed on the scribe head 2 and the air cylinder allows the holder assembly 3 to move up and down along a linear guide.

The two cameras 4 are each set on pedestals 12, respectively. The pedestals 12 can move along a guide 14 that extends in the X direction and are disposed on a support stand 13. The two cameras 4 can move vertically up or down, and an image captured by each camera 4 is displayed on the corresponding monitor 5. Here, alignment marks to identify the position are disposed on a face of the solar cell substrate W. By capturing images of these alignment marks with the two cameras 4, the position of the alignment marks can be identified. Then, directional inaccuracies in the solar cell substrate W placed on the table 1 can be determined based on the identified position of the alignment marks.

### Holder assembly

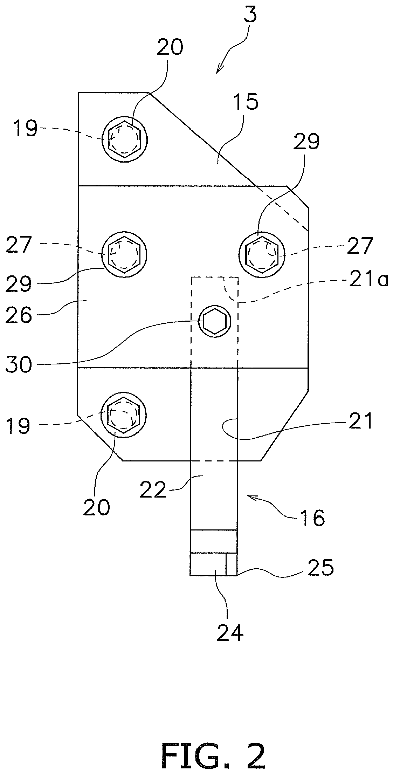

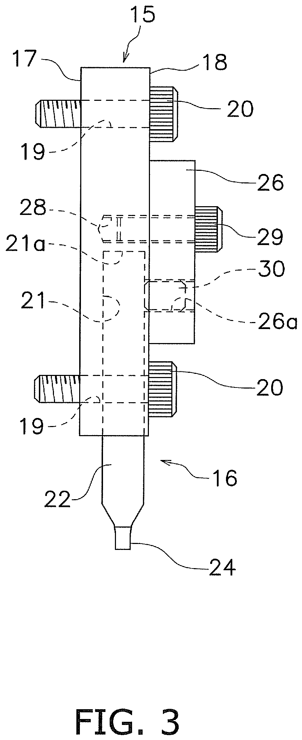

The holder assembly 3 is secured to one face of the scribe head 2. The holder assembly 3 can move in the X and Y directions together with the scribe head 2, and can move vertically up and down with respect to the scribe head 2. The holder assembly 3 is illustrated in FIGS. 2 and 3. FIG. 2 is a front view of the holder assembly 3, and FIG. 3 is a side view thereof.

The holder assembly 3 includes a holder 15 secured to the scribe head 2, a groove machining tool 16 supported by the holder 15, and a fixing plate 26.

### Holder

The holder 15 is a plate-shaped member, and includes a first main face 17 mounted to the scribe head 2 and a second main face 18 on the opposite side. Two through holes 19 are formed vertically on the holder 15, and the holder 15 is secured to the scribe head 2 by two bolts 20 passing completely via each of the through holes 19. Also, a groove 21 of predetermined length is formed on the holder 15 running from the bottom to the top thereof. The groove 21 is formed on the second main face 18, and is a square-shaped groove having a predetermined depth. A stop face 21a is formed on the top part of groove 21. The top edge face of the groove machining tool 16 abuts the stop face 21a and thereby controlling upward movement of the groove machining tool 16.

### Groove machining tool

The groove machining tool 16 is inserted into the square groove 21 of the holder 15, and, as previously stated, the top edge face of the groove machining tool 16 abuts the stop face 21a of the square groove 21. The groove machining tool 16 is constituted by tool body 22 and a blade tip part 24, and is formed of a hard material such as cemented carbide or sintered diamond.

The tool body 22 is formed into a square shape corresponding to the square groove 21 of the holder 15. The bottom portion of the tool body 22, in other words, the portion that connects with the blade tip part 24, is a tilted face tapered downward, as viewed from the direction of movement of the tool (the right side of FIG. 2). The blade tip part 24 is formed integrally with the tool body 22 at the tip end of the same tool body 22.

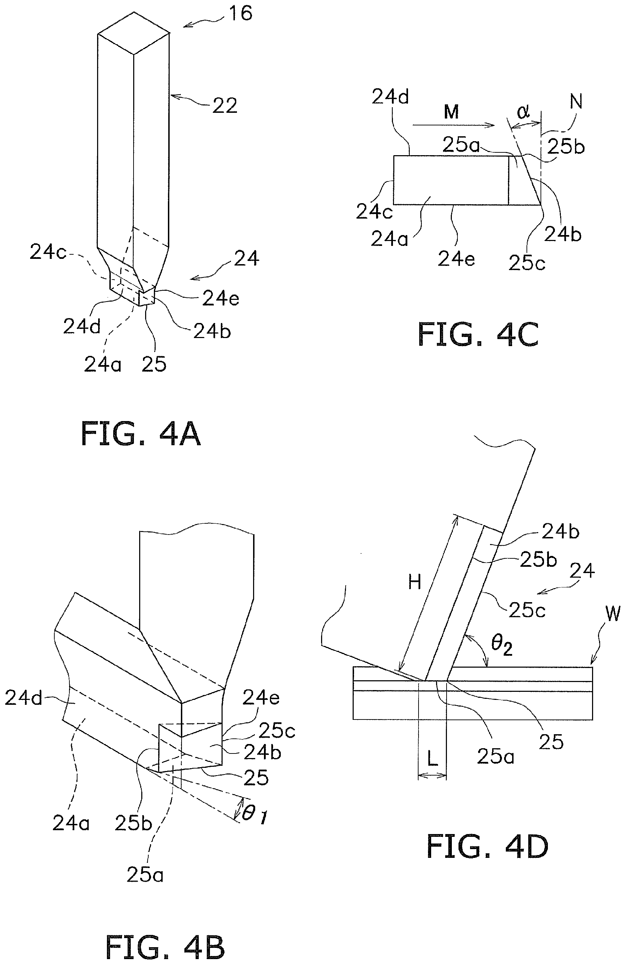

The details of the blade tip part 24 are illustrated in FIGS. 4A to 4D. FIG. 4B is an expanded view of one portion of FIG. 4A, and FIG. 4C is a diagram of the blade tip part 24 as viewed from the bottom face. Further, FIG. 4D is an expanded view of the position of the tool during machining.

The blade tip part 24 has a bottom face 24a, an anterior face 24b, a posterior face 24c; and a first-side face 24d and a second-side face 24e, being opposing faces.

A blade tip face 25a is formed on one lengthwise end part of the bottom face 24a, and is tilted at a predetermined angle θ1 with respect to the bottom face 24a. The blade tip face 25a is a parallel face to the surface of the table 1, in other words, to the substrate surface W, in a machining position wherein the groove machining tool 16 is mounted to the head. Further, the anterior face 24b and the blade 25, which is the leading edge of the anterior face 24b, are tilted at the angle α backward from the direction of movement of the tool with respect to an imaginary line N that is orthogonal to the direction of movement M of the tool. An angle of between 5 degrees and 35 degrees, inclusive, is desirable for the angle of tilt α. By causing the anterior face 24b and the blade 25 to tilt in this way, one pair of edges 25b and 25c are formed at both ends of the width direction of the blade (the direction of thickness of the blade tip part 24). When viewed from the bottom face, one of the edges 25b forms an obtuse angle, and the other edge 25c forms an acute angle.

One example of the blade tip face 25a and the anterior face 24b in this configuration is given below:
Length (L) of the blade tip face 25a : 5 to 15 µm
Height (H) of the front face 24b : 0.5 to 0.7 mm

These values are only one example, and various alterations are possible according to such factors as the thin film material used and the materials used in the tool, etc.

When machining using the groove machining tool 16 described above, the anterior face 24b and the posterior face 24c of the blade tip part 24 are set so that they are tilted θ2 degrees with respect to the surface of the solar cell substrate W, as illustrated in FIG. 4D. As previously stated, by setting the groove machining tool 16 in this kind of position, the blade tip face 25a becomes parallel to the substrate surface W when machining. In this kind of machining position, the blade tip face 25a becomes parallel to the substrate surface W, thereby the surface that includes the bottom portion of the one pair of edges 25b and 25c, and the blade 25 (the leading edge of the anterior face 24b) becomes parallel with the substrate surface W.

An angle of 65° to 75° is desirable for the angle θ2. Peeling-off of excess film when a groove is formed can be reduced by mounting the groove machining tool 16 at such a tilt angle.

### Fixing plate

As illustrated in FIGS. 2 and 3, two through- holes 27 are formed in the fixing plate 26, being aligned horizontally. The fixing plate 26 is attached to the second main face 18 of the holder 15 by two bolts 29 being screwed into corresponding screw holes 28 of the holder 15 and passing through each of the through holes 27. In this way, the fixing plate 26 covers approximately the top one third of the groove machining tool 16 inserted into the square groove 21 of the holder 15.

A screw hole 26a is formed in, and passes through, the fixing plate 26. The screw hole 26a is disposed in a position such that the hole faces the groove machining tool 16 in the condition wherein the fixing plate is attached to the holder 15. By screwing a screw member 30 into this screw hole 26a, the end of the screw member 30 presses on the groove machining tool 16 against a bottom face of the square groove 21. Thereby, the groove machining tool 16 is prevented from falling out of the square groove 21.

### Mounting the groove machining tool

When forming a groove on the thin film of substrate W, the blade tip face 25a of the groove machining tool 16 is set so that it is parallel to the substrate surface W, and the groove machining tool 16 is caused to move along the direction of the creation of the groove. Therefore, it is necessary to mount the groove machining tool 16 at an appropriate mounting angle to the holder 15.

According to the present embodiment, the tool body 22 is square and the square groove 21 is formed in the holder 15, therefore by fitting the square tool body 22 into the square groove 21, the groove machining tool 16 can be fixed at an appropriate angle to the holder 15.

The holder assembly 3 that includes the groove machining tool 16 is set so that the tool itself tilts with a predetermined angle (for example, 70°) with respect to the surface of the solar cell substrate W.

### Operation

The groove machining tool 16 is set into the scribe head 2 so that the tool achieves a machining position such as the one described above. Every time the table 1 is caused to move at a predetermined pitch in the Y direction, the holder assembly 3 is caused to descend, and the blade tip part 25 of the groove machining tool 16 is pressed down onto the surface of the solar cell substrate W. By causing the holder assembly 3 to move in the X direction, a groove running in the X direction is formed on the surface of the solar cell substrate W.

### Experimental example

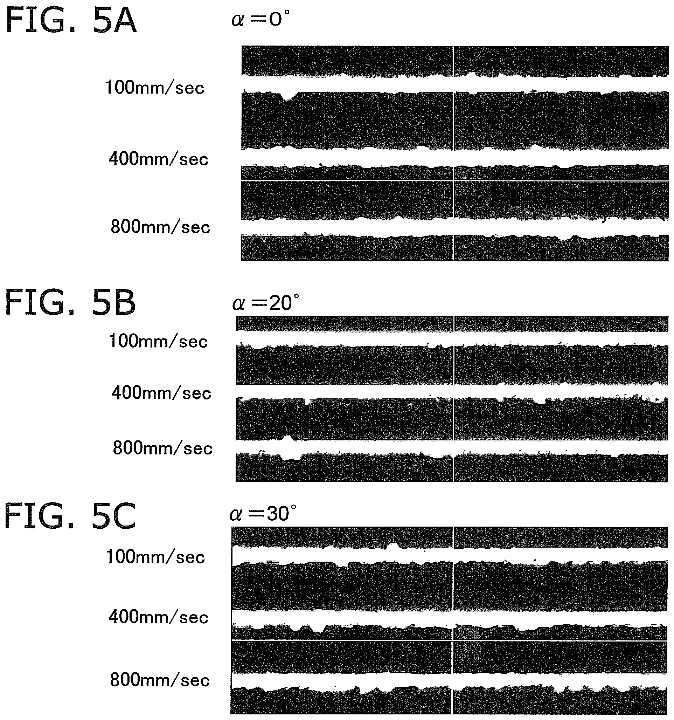

FIGS. 5A to 5C show a monitor image of a case wherein the groove machining tool according to the present embodiment is used to remove the thin film. FIG. 5A shows a case wherein a tool having a blade 25 with a tilt angle of α = 0° is used to machine at movement speeds of 100 mm/sec, 400 mm/sec, and 800 mm/sec. FIG. 5B shows a case wherein a tool having a blade 25 with a tilt angle of α = 20° is used to machine at the same movement speeds. FIG. 5C shows a case wherein a tool having a blade 25 with a tilt angle of α = 30° is used to machine at the same movement speeds. In each drawing, the portions shown in white are portions that have been groove machined, and the portions shown in black are portions where the thin film remains. The upper end of the groove shown in the drawings is the portion that contacts the second face 24e of the blade tip part 24.

As is clear from the drawings, the thin film is removed in a wave shape at both ends of the groove when α = 0°, and the machining quality of the groove decreases. On the other hand, when α = 20° or α = 30°, the top end of the groove (the portion that contacts the edge 25c formed into an acute angle) is machined into a comparatively straight line, and the machining quality is good.

The following things are understood from the above experiment results:
(a) The shearing effect achieved by a knife edge formed into an acute angle is improved by tilting the blade 25 from a direction orthogonal to the direction of movement of the tool.
(b) The film removed by the edge portion of the blade 25 is smoothly expelled by the tilt of the blade 25, and the negative impact of the removed film on machining can be reduced.

### Characteristics of the first embodiment

(1) The blade 25 of the blade tip part 24 is tilted with respect to the direction of movement of the tool as viewed from a bottom face. Therefore, the shearing effect of the knife edge on ends of the groove in the width direction improves when a groove is formed by the groove machining tool. For this reason, peeling-off of film at the groove ends from portions outside the groove can be reduced.
(2) The film removed when machining a groove is smoothly expelled from one end of the groove to the center of the groove along the anterior face 24b formed above the blade 25. For this reason, worsening of cutting performance by the removed film is reduced, and a groove can be machined with stable, high quality.
(3) The square tool body 22 is fitted into the square groove 21 of the holder 15, and the mounting angle of the groove machining tool 16 is reduced. For this reason, the groove machining tool 16 can be mounted into the holder 15 consistently in a stable position with an extremely simple construction and a simple mounting process. Therefore, the machining quality of a groove formed by this kind of groove machining tool 16 is stabilized.

The blade tip part 24 of the groove machining tool 16 extends at the same width continually along the total length of the tool body 22 along the direction that the groove is formed. For this reason, even if the blade 25 is worn down due to friction, the cutting effect of the blade can be restored simply by repair machining the blade tip, and the life of the tool can be extended.

### Modification of the first embodiment, which is not part of the present invention

When a groove is machined along a scribe line in this arrangement, the following cases exist: (A) the case wherein the film peeling off at one end of the groove is allowable, and (B) the case wherein peeling-off of the film at both ends of the groove must be reduced. In the case of (A), by machining a groove using the previously mentioned groove machining tool 16, a groove of the desired quality can be obtained. On the other hand, in the case of (B), a groove of satisfactory quality cannot be obtained with the groove machining tool illustrated in FIG. 4.

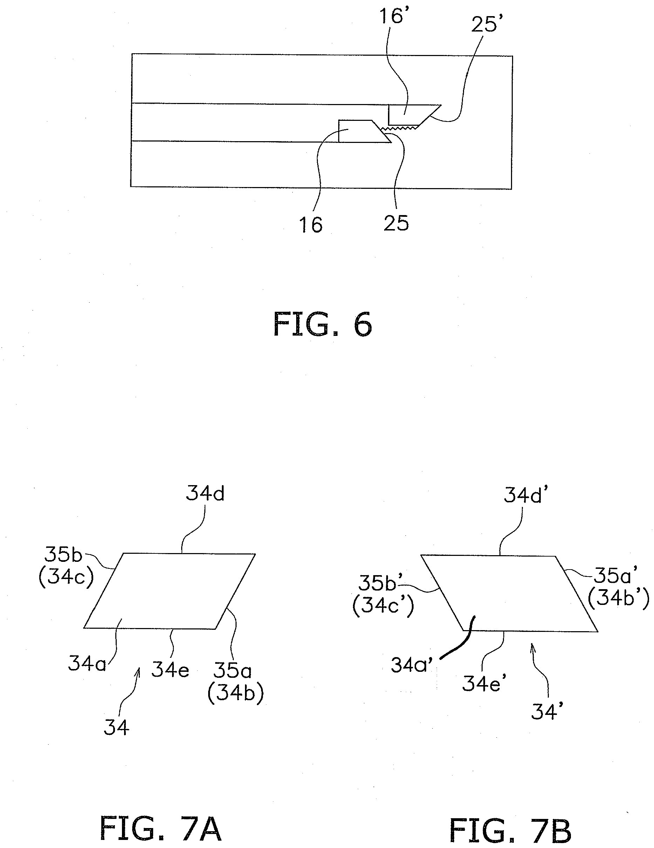

In the case of (B), obtaining a film of the desired quality is possible according to the construction illustrated in FIG. 6. In other words, groove machining using a pair of groove machining tools wherein the tilt angles of the blades of the blade tip parts are opposite is acceptable. The two groove machining tools illustrated in FIG. 6 are only the schematically illustrated forms of the blade tip parts as viewed from a bottom face.

In this arrangement, a first groove machining tool 16 that is the same as the first embodiment, and a second groove machining tool 16' wherein the angle of the blade is opposite from the first groove machining tool 16 are used. The two groove machining tools 16 and 16' are fixed with respect to the holder. In this case, one of the groove machining tools 16 and 16' is placed upstream of the other groove machining tool in the direction of movement of the tool.

Machining quality can be improved at both ends of the groove by using such groove machining tools 16 and 16'.

### Second embodiment, which is not part of the present invention

According to the first embodiment, the blade 25 of the blade tip part 24 was placed at only one end in the direction of movement of the tool. However, it is acceptable to place blade tip parts 34 and 34' at both ends in the direction of movement of the tool, as illustrated in FIGS. 7A and 7B. FIGS. 7A and 7B are drawings of the blade tip part 34 as viewed from a bottom face.

Specifically, the blade tip part 34 illustrated in FIG. 7A has a bottom face 34a, an anterior face 34b and a posterior face 34c, and a first face 34d and a second face 34e, which are opposing faces. Blades 35a and 35b exist at the bottom end of each of the anterior face 34b and the posterior face 34c of the blade tip part 34 and extend in a direction intersecting the direction of movement M of the tool. The blades 35a and 35b of the blade tip part 34 are tilted at the same angle and in the same direction as each other with regard to a direction orthogonal to the direction of movement M of the tool.

The blade tip part 34' illustrated in FIG. 7B is also constructed in approximately the same manner. In other words, the blade tip part 34' has a bottom face 34a', an anterior face 34b' and a posterior face 34c', and a first face 34d' and a second face 34e', being opposing faces. Blades 35a' and 35b' exist at the bottom end of each of the anterior face 34b' and the posterior face 34c'. The blades 35a' and 35b' in the blade tip part 34' illustrated in FIG. 7B are tilted in an opposite direction at the same angle as the blades 35a and 35b.

By using a groove machining tool that has blade tip parts 34 and 34' as described above, when one of the blades 34a or 35a' is worn down due to friction, the mounting direction of the groove machining tools is reversed, and the other blades 35b and 35b' can continue to used for machining.

### Third Embodiment, which is not part of the present invention

### Groove Machining Tool

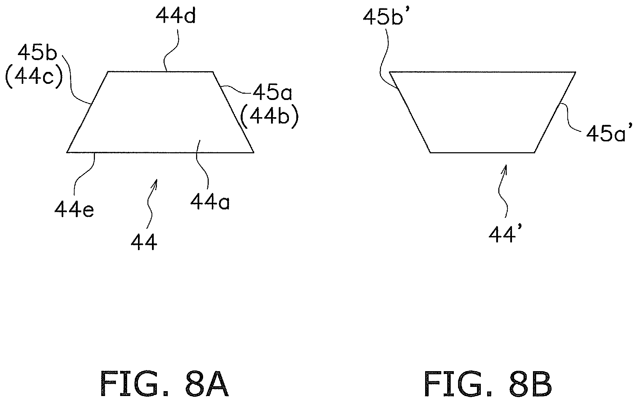

FIGS. 8A and 8B illustrate a groove machining tool that uses a reciprocating head according to a third embodiment. FIGS. 8A and 8B are drawings of the blade tip part as viewed from a bottom face.

In this arrangement, a "groove machining tool that uses a reciprocating head" means a tool wherein one end of the groove can be machined when moving in either of the two directions, both coming and going.

More specifically, a blade tip part 44 of one of the tools has a bottom face 44a, an anterior face 44b and a posterior face 44c, and a first face 44d and a second face 44e, being opposing faces. Blades 45a and 45b exist at the bottom end of each of the anterior face 44b and the posterior face 44c of the blade tip part 44 and extend in a direction intersecting the direction of movement M of the tool. The blades 45a and 45b of the blade tip part 44 are tilted at the same angle in opposite directions from each other with respect to a direction orthogonal to the direction of movement M of the tool.

First, when machining a groove using a groove machining tool having such a blade tip part 44, a groove is machined by one of the blades 45a when moving in the coming direction. At this time, one of the ends of the groove is cut by the edge portion of the blade 45a, and the machining quality of one end part of the groove is therefore improved. When moving in the going direction, the position of the head wherein the groove machining tool is installed moves, and an end of a groove adjacent to the groove previously machined is machined by the blade 45b. At this time, one of the ends of the groove is cut by the edge portion of the blade 45b, and the machining quality of one end of the groove is therefore improved in the same way as the previous machining.

The construction of the blade tip part 44' of the other groove machining tool is the same, and only the direction of tilt of the blades 45a' and 45b' differs from the blade tip part 44 of the first tool.

### Reciprocating head

As previously, when machining in this arrangement it is necessary to cause the tool itself to tilt with regard to the substrate surface. A head in which a tool such as the one shown in FIG. 8A or 8B is installed supports the tool so that it can wobble. It is necessary to change the angle of tilt of the tool when the tool is moving in the coming and the going directions, respectively.

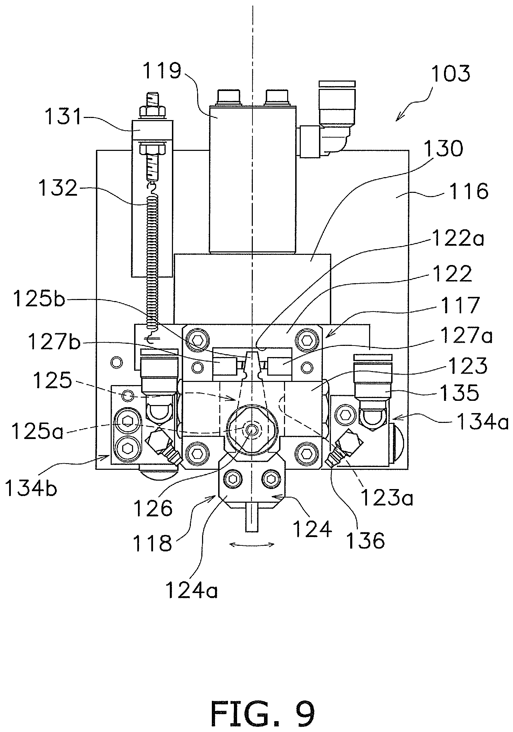

The configuration of such a head is illustrated in FIG. 9. A reciprocating head 103 has a board shaped base 116, a holder 117, a wobble member 118, and an air cylinder 119.

The holder 117 is supported via a rail (not shown) so that it can slide freely in the vertical direction with regard to the base 116. The holder 117 has a holder body 122, and a support member 123 is fixed to the surface of the holder body 122. The holder body 122 is formed in a board shape and has an opening 122a at its upper end. The support member 123 is a rectangular member that is long in the transverse direction, and is provided with a through-hole 123a for accommodating the wobble member 118 in the interior thereof.

The wobble member 118 has a tool mounting part 124 on the lower portion of the wobble member and an extension part 125 formed extending upwards from the tool mounting part 124. A groove is formed on the tool mounting part 124 and the tool is inserted into this groove. The tool is fixed to the inside of the groove by a fixing plate 124a. On the bottom portion of the extension part 125 in the horizontal direction, a hole 125a is formed passing through in a direction orthogonal to the direction of formation of the groove. The wobble member 118 capable of wobbling about a pin 126 that passes through the hole 125a. A pair of regulation members 127a and 127b is disposed on both the left and the right sides of a top end 125b of the extension part 125. The regulation members 127a and 127b have a tubular member acting as a stopper fixed to the holder body 122 and a spring inserted into the interior of the tubular member. The wobble member 118 is maintained at a central location as illustrated in FIG. 9 due to the fact that the end of each spring abuts with the top end 125b of the extension part 125. The wobble angle is regulated by the fact that the wobble member 118 wobbles and presses one of the springs, and the top end 125b of the extension part 125 abuts with the tubular member.

The air cylinder 119 is fixed to the upper surface of a cylinder support member 130. The cylinder support member 130 is disposed at the upper portion of the holder 117 and is fixed to the base 116. A hole passing in a vertical direction is formed in the cylinder support member 130. A piston rod (not shown) of the air cylinder 119 passes through this hole, and the tip of the rod connects with the holder 117.

A spring support member 131 is disposed on the upper portion of the base 116. A spring 132 is disposed between the spring support member 131 and the holder 117. The holder 117 is urged upwards by the spring 132. The weight of the holder 117 can be approximately cancelled by the spring 132.

A pair of air supply units 134a and 134b is disposed on both the right and the left sides of the holder 117. Each air supply unit 134a and 134b is constructed in the same way and both have a joint 135 and an air nozzle 136.

### Groove machining operation

The air cylinder 199 is moved and the holder 117 and the wobble member 118 are caused to descend, and the end of the tool is placed on the thin film when machining a groove using such a device. The pressure of the tool on the thin film at this time is regulated by the air pressure supplied to the air cylinder 119.

Next, the head 103 is caused to move along a scheduled scribe line. The wobble member 118 wobbles clockwise manner about the pin 126 according to the contact resistance between the blade of the tool and the thin film on the substrate when moving in the coming direction. The wobbling is regulated by the fact that the top end 125b of the wobble member abuts with the right side regulation member 127a. Therefore, the tool moves in a position with a predetermined angle of tilt, and a groove is formed.

Thereafter, the head 103 is caused to move relative to the substrate and the tool is caused to move to the scheduled scribe line onto which it should descend. As previously described, the tool is pressed on the thin film on the substrate, and the head 103 is caused to move in the opposite direction as previously.

While moving in the going direction the wobble member 118 wobbles counterclockwise about the pin 126 according to the contact resistance between the blade of the tool and the thin film on the substrate. The wobbling is regulated by the fact that the top end 125b of the wobble member abuts with the left side regulation member 127b. Therefore, the tool 2 moves in a position wherein it is tilted opposite to the tilt when moving in the coming direction, and the groove is formed.

According to such operations, a groove can be machined when the tool moves back and forth. In the reciprocating head an air cylinder or other actuator may be installed to change the wobble angle of the wobble member 118.

### Fourth embodiment, which is not part of the present invention

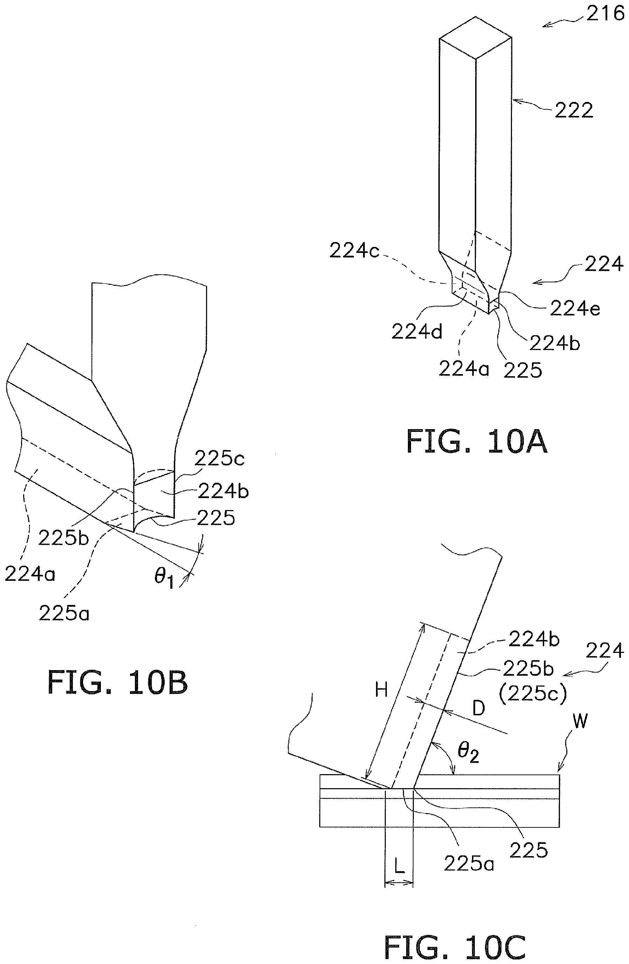

The modification of the first embodiment illustrated in FIG. 6 used two groove machining tools and machined each of the two edges of the groove using one of the edge portions of the tool, respectively. However, it is acceptable to machine both ends of the groove with the edge portion of one tool. The groove machining tool used in this case is illustrated in FIG. 10. The groove machining tool of the fourth embodiment is only different from the first embodiment in the shape of the blade tip part.

The blade tip part 224 of the groove machining tool 216 illustrated in FIG. 10 has a bottom face 224a, an anterior face 224b and a posterior face 224c, and a first face 224d and a second face 224e, being opposing faces.

The bottom face 224a is formed into a rectangle. The posterior face 224c extends upward orthogonally to the bottom face 224a and is the same flat face as the face of the tool body 222. The first and the second faces 224d and 224e extend upward orthogonally to the bottom face 224a from the long side of the bottom face 224a, and are parallel to each other. The portion that connects the first and the second face 224d and 224e in the bottom portion of the tool body 222 is a tilted face that is tapered downward in the same way as in the first embodiment.

The blade tip part 224 of the groove machining tool 216 extends continually along the entire length of the tool body 222 with the same width along the direction that the groove is formed.

A blade 225 is formed by the angular portion between the bottom face 224a and the bottom portion of the anterior face 224b in the blade tip part 224. The blade 225 will be explained in detail below. FIG. 10B is an expanded view of one portion of FIG. 10A, and that FIG. 10C is an expanded view of the position of the tool when machining.

A blade tip face 225a that is tilted at a predetermined angle θ1 with regard to the bottom face 224a is formed on one end of the longitudinal direction of the bottom face 224a. The blade tip face 225a is a face that is parallel with the surface of the table 1, in other words, the substrate surface W, when in a machining position wherein the groove machining tool 216 is mounted in the head. The anterior face 224b and the blade 225 being the tip edge of the anterior face 224b form a curved face that sinks towards the inside. One pair of edges 225b and 225c are formed on both ends along the direction in the width of the blade (the thickness direction of the blade tip part 224) by forming this curved face. A flank part (concave at the anterior face 224d) is formed between the one pair of edges 225b and 225c that sinks towards the inside.

One example of the blade 225 according to this arrangement is given below:
Length of blade tip face 225a L : 5 to 15 µm
Height of anterior face (the blade and the flank part) H : 0.5 to 0.7 mm
Depth of the anterior face (the curved surface portion = the flank part) D : 3 to 5 µm

These values are one example, and various alterations are possible according to the thin film materials and the materials used in the tool.

When machining using such a groove machining tool 216, the anterior face 224b and the posterior face 224c of the blade tip part 224 are set with respect to the solar cell substrate W such that they are tilted at angle θ2 with respect to the substrate surface, as illustrated in FIG. 10C. By setting the groove machining tool 216 in such a position, the blade tip face 225a becomes parallel with the substrate surface when machining, as previously stated. The blade tip face 225a becomes parallel with the substrate surface W in such a position. Therefore, the face that includes the pair of edges 225b and 225c that comprise the blade 225, and the blade 225 (the tip edge of the anterior face 224b) becomes parallel with the face of the substrate.

An angle 65° to 75° is desirable for angle θ2. By mounting the groove machining tool 216 at this angle of tilt and machining, the peeling-off of extra film when forming a groove can be reduced.

### Characteristics of the fourth embodiment, which is not part of the present invention

In the present embodiment, thin film is scribed in a machining position wherein one pair of edges 225b and 225c, as well as the blade 225 are parallel with the substrate surface. For this reason, a groove of good machining quality with minimal film separation and detachment around the groove ends can be formed in one step. Even if the edges 225b and 225c become worn down due to friction, the whole of the blade tip will resist becoming round due to the existence of the one pair of edges 225b and 225c and the flank part. Therefore, formation of stable quality grooves is possible for a long period of time.

### Modification of the fourth embodiment, which is not part of the present invention

In the embodiment described above, the blade portion is formed into the shape of a U, when viewed from a bottom face. However, the same results are obtainable by forming the blade portion into the shape of a V.

### Other embodiments

(a) In the previous embodiments, the whole of the tool body was made to be square. However, the tool body may alternatively be formed into a round rod. In this case as well, if the blade tip part and the blade tip are formed in the same way as the previous embodiments, a groove of high machining quality can be formed by a one-step process, in the same way as the previously described embodiments. Also, stable quality grooves can be formed for a long period of time.
(b) Specific examples of a blade tip are not limited to the previously mentioned examples. In accordance with the specification of materials used in the tool and the thin film material, various alterations are possible.

## Claims

1. A groove machining tool (16) supported in a holder (15) and caused to move together with the holder (15) in relative fashion along a scheduled scribe line over an integrated thin-film solar cell substrate (W) to form a groove, the groove machining tool (16) comprising:
a tool body (22) supported in the holder (15); and
a blade tip part (24) formed in a distal part of the tool body (22), **characterised in that**: the blade tip part (24) has a bottom face (24a), an anterior face (24b), a posterior face (24c), and a first-side face (24d) and a second-side face (24e) being opposing faces,
a blade tip face (25a) is formed on one lengthwise end part of the bottom face (24a) and is tilted at a predetermined angle (θ1) with respect to the bottom face (24a), the blade tip face (25a) being a parallel face to the surface of a substrate surface (W) in a machining position in which the groove machining tool (16) is mounted to a head (2),
the anterior face (24b) and a blade (25) of the blade tip part (24), which is the leading edge of the anterior face (24b), are tilted at an angle (α) backward from the second-side face (24e) to the first-side face (24d) when viewed from the bottom face (24a) such that a pair of edges (25b, 25c) are formed at both ends of the direction of thickness of the blade tip part (24), and
when viewed from the bottom face (24a), one (25b) of the edges (25b, 25c) forms an obtuse angle and the other (25c) of the edges (25b, 25c) forms an acute angle.

2. The groove machining tool (16) for use with a thin-film solar cell according to claim 1, wherein
the blade tip part (24) extends at the same thickness along the entire width of the tool body (22) along the direction in which the groove is formed on the thin-film.

3. The groove machining tool (16) for use with a thin-film solar cell of claim 1, wherein
the tool body (22) is formed into a square shape.

## Patentansprüche

1. Rillenbearbeitungswerkzeug (16), das in einer Halterung (15) gestützt ist und das gestaltet ist, um sich gemeinsam mit der Halterung (15) in einer relativen Weise entlang einer planmäßigen Ritzlinie über ein integriertes Dünnfilmsolarzellensubstrat (W) zu bewegen, um eine Rille auszubilden, wobei das Rillenbearbeitungswerkzeug (16) Folgendes aufweist:
einen Werkzeugkörper (22), der in der Halterung (15) gestützt ist; und
einen Schneidenspitzenteil (24), der in einem distalen Teil des Werkzeugkörpers (22) ausgebildet ist,
**dadurch gekennzeichnet, dass**:
der Schneidenspitzenteil (24) eine untere Fläche (24a), eine vordere Fläche (24b), eine hintere Fläche (24c) und eine Fläche (24d) an einer ersten Seite und eine Fläche (24e) an einer zweiten Seite hat, die entgegengesetzte Flächen sind,
eine Schneidenspitzenfläche (25a) an einem longitudinalen Endteil der unteren Fläche (24a) ausgebildet ist und in einem vorbestimmten Winkel (θ1) in Bezug auf die untere Fläche (24a) geneigt ist, wobei die Schneidenspitzenfläche (25a) eine parallele Fläche zu der Oberfläche einer Substratoberfläche (W) in einer Bearbeitungsposition ist, in der das Rillenbearbeitungswerkzeug (16) an einem Kopf (2) montiert ist,
die vordere Fläche (24b) und eine Schneide (25) des Schneidenspitzenteils (24), die die führende Kante der vorderen Fläche (24b) ist, in einem Winkel (α) von der Fläche (24e) an der zweiten Seite zu der Fläche (24d) an der ersten Seite aus Sicht von der unteren Fläche (24a) nach hinten derart geneigt sind, dass ein Kantenpaar (25b, 25c) an beiden Enden der Dickenrichtung des Schneidenspitzenteils (24) ausgebildet ist, und
aus Sicht von der unteren Fläche (24a) eine (25b) der Kanten (25b, 25c) einen stumpfen Winkel ausbildet und die andere (25c) der Kanten (25b, 25C) einen spitzen Winkel ausgebildet.

2. Rillenbearbeitungswerkzeug (16) zur Verwendung mit einer Dünnfilmsolarzelle nach Anspruch 1, wobei
sich der Schneidenspitzenteil (24) mit derselben Dicke entlang der gesamten Breite des Werkzeugkörpers (22) entlang der Richtung erstreckt, in der die Rille an dem Dünnfilm ausgebildet wird.

3. Rillenbearbeitungswerkzeug (16) zur Verwendung mit einer Dünnfilmsolarzelle nach Anspruch 1, wobei
der Werkzeugkörper (22) in einer viereckigen Form ausgebildet ist.

## Revendications

1. Machine pour usiner une rainure (16) supportée dans un support (15) et amenée à se déplacer conjointement avec le support (15) d'une manière relative le long d'une ligne de découpe prévue sur un substrat de cellule solaire à couche mince (W) intégré afin de former une rainure, la machine pour usiner une rainure (16) comprenant :
un corps de machine (22) supporté dans le support (15) ; et
une partie de pointe de lame (24) formée dans une partie distale du corps de machine (22),
**caractérisée en ce que** :
la partie de pointe de lame (24) a une face inférieure (24a), une face antérieure (24b), une face postérieure (24c) et une première face latérale (24d) et une seconde face latérale (24e) qui sont des faces opposées,
une face de pointe de lame (25a) est formée sur une partie d'extrémité dans le sens de la longueur de la face inférieure (24a) et est inclinée à un angle (θ1) prédéterminé par rapport à la face inférieure (24a), la face de pointe de lame (25a) étant une face parallèle à la surface d'une surface de substrat (W) dans une position d'usinage dans laquelle la machine pour usiner une rainure (16) est montée sur une tête (2),
la face antérieure (24b) et une lame (25) de la partie de pointe de lame (24), qui est le bord d'attaque de la face antérieure (24b), sont inclinées à un angle (α) vers l'arrière, de la seconde face latérale (24e) vers la première face latérale (24d) lorsqu'elles sont observées à partir de la face inférieure (24a), de sorte qu'une paire de bords (25b, 25c) est formée au niveau des deux extrémités de la direction d'épaisseur de la partie de pointe de lame (24), et lorsqu'ils sont observés à partir de la face inférieure (24a), l'un (25b) des bords (25b, 25c) forme un angle obtus et l'autre (25c) des bords (25b, 25c) forme un angle aigu.

2. Machine pour usiner une rainure (16) destinée à être utilisée avec une cellule solaire à couche mince selon la revendication 1, dans laquelle :
la partie de pointe de lame (24) s'étend à la même épaisseur le long de toute de largeur du corps de machine (22) le long de la direction dans laquelle la rainure est formée sur la couche mince.

3. Machine pour usiner une rainure (16) destinée à être utilisée avec une cellule solaire à couche mince selon la revendication 1, dans laquelle :
le corps de machine (22) est formé selon une forme carrée.
